# EUROPEAN PATENT APPLICATION

(11) **EP 4 749 296 A1**
(43) Date of publication of application: **27.05.2026**
(21) Application number: 25218165.6
(22) Date of filing: 24.11.2025
(51) Int. Cl.: G01R 1/04

(54) **INTELLIGENT BRANCH CIRCUIT METERING SYSTEM**

(30) Priority: 25.11.2024 US 202463724777 P; 21.11.2025 US 202519397469
(71) Applicant: Vertiv Corporation, Westerville, OH 43082 (US)
(72) Inventor: FERGUSON, Kevin R., Westerville, 43082 (US); SAMBORSKY, Matt, Westerville, 43082 (US)
(74) Representative: Bryn-Jacobsen, Caelia

(57) **Abstract**

A sensor assembly may include a base, a first wing coupled to a first side of the base, and a second wing coupled to a second side of the base, wherein the base, the first wing, and the second wing form a cavity. A sensor assembly may include at least one terminal block disposed within the cavity and communicatively coupled to a controller. A sensor assembly may include a plurality of current transformers, wherein one or more current transformers of the plurality of current transformers are wholly or partially removably couplable to the at least one terminal block when the first wing and the second wing are arranged in an open configuration, wherein the one or more current transformers of the plurality of current transformers are not removable from the at least one terminal block when the first wing and the second wing are arranged in a closed configuration.

## Description

### CROSS REFERENCE TO RELATED APPLICATION

This application claims the benefit of priority of U.S. Provisional Application No. 63/724,777, filed November 25, 2024.

### TECHNICAL FIELD

The present disclosure relates generally to branch circuit monitoring, and more particularly to systems and related componentry for monitoring branch circuits.

### BACKGROUND

Branch circuit monitors provide tracking and recording of one or more parameters of an electrical circuit. For example, these branch circuit monitors, often containing a plurality of current transformers, may monitor the amperage, voltage, power factor, and/or energy usage of a circuit. Often, these branch circuit monitors are located adjacent to, or integrated within, circuit breaker boxes, where they must fit within specific dimensions. Branch circuit monitors often include rigid, monolithic sensor supports for mounting current transformers (CTs) and bussing their wires to an external connection. The external connection is then attached via additional cabling to a centralized power metering system. The rigid and monolithic design of the branch circuit monitor prevents easy customization and repair. For example, the replacement of a defective current transformer within branch circuit monitors may require removal of part or all of the sensor support to expose the plurality of current transformers. The data connection from each current transformer to the centralized power metering system often requires a complicated wiring design.

Therefore, there is a need for a branch circuit monitor that provides for easier implementation and repair, or sensor upgrade retrofit than current systems.

### SUMMARY

In embodiments, a sensor assembly for wiring in an electrical system is disclosed. In one or more embodiments, the sensor assembly includes a sensor support. In one or more embodiments, the sensor support includes a base; a first wing coupled to a first side of the base; and a second wing coupled to a second side of the base, wherein the base, the first wing, and the second wing form a cavity. In one or more embodiments, the sensor assembly includes at least one terminal block disposed within the cavity and communicatively coupled to a controller. In one or more embodiments, the sensor assembly includes a plurality of current transformers, wherein one or more current transformers of the plurality of current transformers are removably couplable to the at least one terminal block when the first wing and the second wing are arranged in an open configuration, wherein the one or more current transformers of the plurality of current transformers are not removable from the at least one terminal block when the first wing and the second wing are arranged in a closed configuration.

In embodiments, a circuit breaker panel is disclosed. In one or more embodiments, the sensor assembly includes a plurality of circuit breakers. In one or more embodiments, the circuit breaker panel includes a sensor assembly. In one or more embodiments, the sensor assembly includes a sensor support. In one or more embodiments, the sensor support includes a base; a first wing coupled to a first side of the base; and a second wing coupled to a second side of the base, wherein the base, the first wing, and the second wing form a cavity. In one or more embodiments, the sensor assembly includes at least one terminal block disposed within the cavity and communicatively coupled to a controller. In one or more embodiments, the sensor assembly includes a plurality of current transformers communicatively coupled to the plurality of circuit breakers, wherein one or more current transformers of the plurality of current transformers are removably couplable to the at least one terminal block when the first wing and the second wing are arranged in an open configuration, wherein the one or more current transformers of the plurality of current transformers are not removable from the at least one terminal block when the first wing and the second wing are arranged in a closed configuration.

In embodiments, a method for replacing a defective current transformer from a sensor assembly is disclosed. In one or more embodiments, the method includes: moving at least one of a first wing or a second wing of a sensor support of the sensor assembly to from a first position to a second position, wherein moving the at least one of the first wing or the second wing of a sensor support of the sensor assembly from the first position to the second position causes the at least one of the first wing or the second wing of the sensor support of the sensor assembly to articulate from a closed configuration to an open configuration; removing a first current transformer from a first block connector of a terminal block of the sensor assembly; inserting a second current transformer into the first block connector of the terminal block of the sensor assembly; and moving the at least one of the first wing or the second wing of the sensor support of the sensor assembly from the second position to the first position, wherein moving the at least one of the first wing or the second wing of the sensor support of the sensor assembly from the second position to the first position causes the at least one of the first wing or the second wing of the sensor support of the sensor assembly to articulate from the open configuration to the closed configuration. The second current transformer may include a split-core transformer. The use of split-core current transformers is particularly advantageous for retrofit applications in which the sensory assembly is installed in a preexisting panel board that lacks current sensing. For example, the split-core lid may be separated so that the branch circuit wiring can be inserted and routed through the core of the split-core transformer, then reinstalled.

The accompanying drawings, which are incorporated in and constitute a part of the specification, illustrate embodiments.

### BRIEF DESCRIPTION OF THE DRAWINGS

The numerous advantages of the disclosure may be better understood by those skilled in the art by reference to the accompanying figures.
FIGS. 1A and 1B are block diagrams illustrating a sensor assembly, in accordance with one or more embodiments of the disclosure.
FIG. 1C is a schematic front view of a circuit breaker panel that includes the sensor assembly, in accordance with one or more embodiments of the disclosure.
FIG. 2A illustrates a perspective view of a sensor assembly, in accordance with one or more embodiments of the disclosure.
FIG. 2B illustrates a partially exploded view of the sensor assembly, in accordance with one or more embodiments of the disclosure.
FIG. 2C illustrates an exploded view of the sensor assembly, in accordance with one or more embodiments of the disclosure.
FIG. 3A illustrates a perspective view of a sensor assembly, in accordance with one or more embodiments of the disclosure.
FIG. 3B illustrates a partially exploded view of the sensor assembly, in accordance with one or more embodiments of the disclosure.
FIG. 3C illustrates an exploded view of the sensor assembly, in accordance with one or more embodiments of the disclosure.
FIG. 3D illustrates a close-up perspective view of a split-core current transformer, in accordance with one or more embodiments of the disclosure.
FIG. 4 illustrates a perspective view of a sensor assembly, in accordance with one or more embodiments of the disclosure.
FIG. 5 illustrates a process flow diagram depicting a method for replacing a defective current transformer from a sensor assembly, in accordance with one or more embodiments of the disclosure.

### DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "embodiments" means that a particular element, feature, structure, or characteristic described in connection with the embodiment is included in at least one embodiment disclosed herein. The appearances of the phrase "in embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

Disclosed is a sensor assembly for branch circuit monitoring. The sensor assembly includes a sensor support, a terminal block disposed within the sensor support that is communicatively coupled to a metering system, and a plurality of current transformers that are wholly or partially removably coupled to the terminal block. The sensor support may include wings that are moveable, enabling the sensor support to switch from an open configuration, allowing individual current transformers to be inserted and removed, and a closed configuration where access to the current transformers is prevented. The sensor assembly allows for easy access and repair of individual current transformers, and simplifies wiring needed for sending data from the individual current transformers to the centralized power metering system or network. In embodiments, the sensor assembly is segmented, simplifying the customization of the sensor assembly.

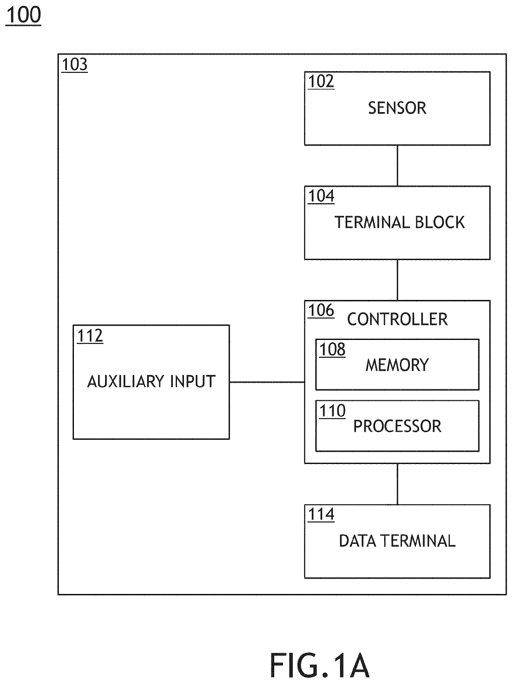

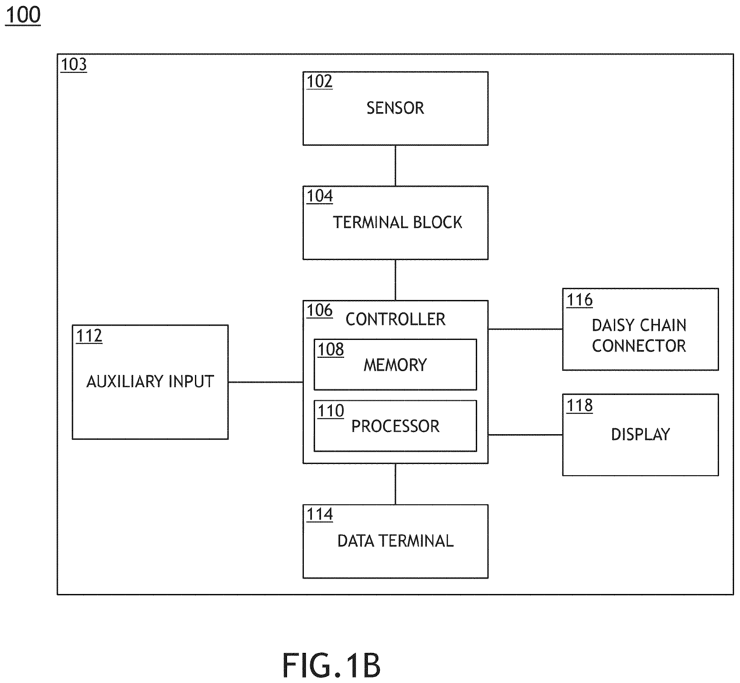

FIGS. 1A and 1B are block diagrams illustrating the sensor assembly 100, in accordance with one or more embodiments of the disclosure. The sensor assembly 100 may be used for gathering circuit flow information from a set of circuits. For example, the sensor assembly 100 may be mounted near or within a circuit breaker panel enclosure, where multiple branches from circuit breakers in the panel can be conveniently monitored from a single location. Systems and methods for branch circuit metering are generally described in United States Patent No. 7,477,501, filed June 2, 2005.

In embodiments, the sensor assembly 100 includes a plurality of sensors 102 disposed within a sensor support 103. The plurality of sensors 102 are configured to detect and/or measure one or more parameters of the set of circuits. For example, the plurality of sensors 102 may include current transformers capable of detecting electrical current flowing through the circuit. For instance, the plurality of sensors 102 may include any type of current transformers including, but not limited to, closed-form current transformers, (e.g., toroidal core current transformers), open-form current transformers (e.g., split-core current transformers or split-core non-contact current transformers), and flying leaded current transformers. The plurality of sensors 102 may also be able to measure other electrical parameters including, but not limited to, voltage, power factor, and energy usage.

In embodiments, the sensor assembly 100 includes one or more terminal blocks 104 configured to removably couple with one or more of the plurality of sensors 102. For example, the plurality of sensors 102 may be pluggable into the terminal blocks 104 (e.g., via block connectors, (not shown)), allowing an operator to simply insert and/or remove the plurality of sensors without requiring soldering or other complicated wiring processes.

In embodiments, one or more of the plurality of sensors 102 include a resistor, such as a burden resistor. For example, the sensors 102 such as current transformers often require a resistor that is connected in parallel to a secondary coil of the current transformer, which converts a current output to a proportional voltage output that may be measured by the one or more controllers 106. In embodiments, the resistor is integrated into the one or more terminal blocks 104. In another embodiment, the resistor is integrated into the controller 106.

In embodiments, the sensor assembly 100 includes one or more controllers 106. The one or more controllers 106 are configured to control one or more aspects of the sensor assembly 100. For example, the controller 106 may be configured to receive an input from the sensor 102 and perform power metering calculations based on the input. In another example, the controller 106 may be configured to transmit an output based on the input and/or power metering calculations. In another example, the controller 106 may be configured to retrieve calibration values and perform a calibration protocol for the sensor assembly. The controller 106 may include one or more processors 108 and a memory 110, the memory 110 storing instructions for the one or more processors 108 to execute the one or more functions of the controller 106.

In embodiments, the sensor assembly 100 includes an auxiliary input 112 for receiving power and/or sensor data. For example, the auxiliary input 112 may be configured to receive 3-phase voltage inputs for supplying power to metering electronics and/or for power calculations.

In embodiments, the sensor assembly 100 includes a data terminal 114 configured to send and/or receive data between the sensor assembly and a data collector, such as a network data collector. For example, the data terminal 114 may be direct-wired for external power metering hookup. In another example, the data terminal 114 utilize wireline or wireless means to send power metering data to the networked data collector. In another example, the data terminal 114 configured to transmit data from the sensor assembly 100 to the data collector.

In embodiments, the sensor assembly 100 includes one or more daisy chain connectors 116, as shown in FIG. 1B, in accordance with one or more embodiments of the disclosure. The one or more daisy chain connectors 116 enable the sensor assembly 100 to mechanically and electrically couple to another sensor assembly 100. For example, the one or more daisy chain connectors 116 may be configured to couple more than two sensor assemblies 100 together in a daisy chain configuration. The one or more daisy chain connectors 116 may be communicatively and/or electrically coupled to the one or more controllers 106.

In embodiments, the sensor assembly 100 includes a display 118 or display port communicatively coupled to the controller 106. For example, the sensor assembly 100 may include a display 118 embedded into the sensor support 103 that displays one or more of the electrical parameters outputted by the controller 106 and/or a status of the sensor assembly 100. In another example, the sensor assembly 100 may include a display port that is couplable to an external display that displays the electrical parameters and/or sensor assembly status.

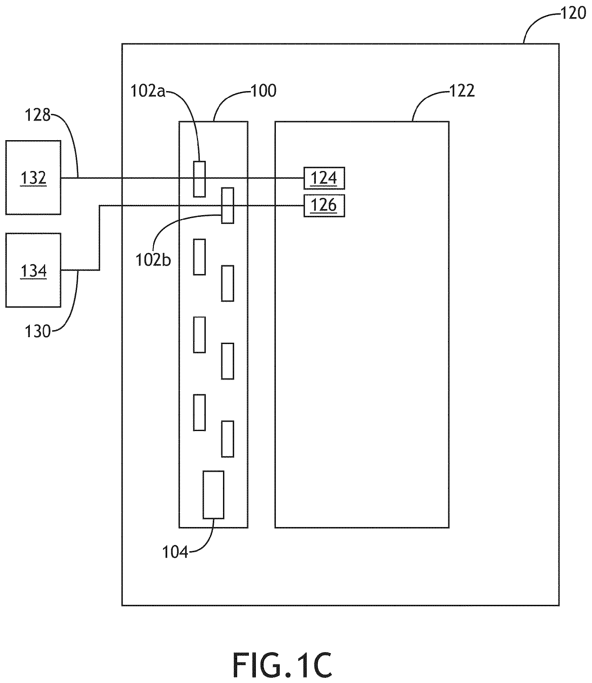

FIG. 1C is a schematic front view of a circuit breaker panel 120 that includes the sensor assembly 100, in accordance with one or more embodiments of the disclosure. The circuit breaker panel 120 may include a circuit breaker assembly 122 having a plurality of circuit breakers 124, 126. wires 128, 130 feed power from the circuit breakers to loads 132, 134. The sensor assembly 100 includes current transformers (e.g., sensors 102a, 102b) mounted thereon used to measure current of the wires 128, 130 passing through the sensors 102a, 102b between the circuit breakers 124, 126 and the loads 132, 134. Signals from the sensors 102a, 102b are transmitted to the controller 106 for processing.

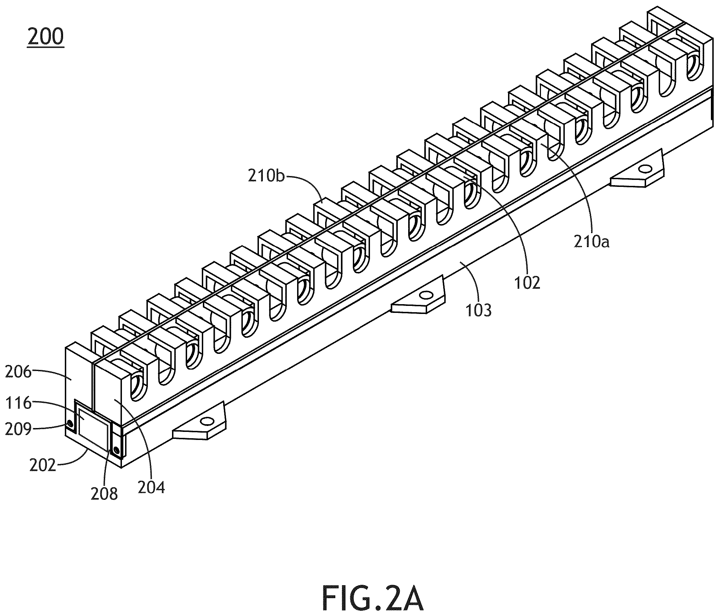

FIG. 2A illustrates a perspective view of a sensor assembly 200, in accordance with one or more embodiments of the disclosure. The sensor assembly 200 may include one or more components of the sensor assembly 100, and vice versa. The sensor support 103 of the sensor assembly 200 includes a base 202, a first wing 204 coupled to the base 202 on a first side, and a second wing 206 coupled to the base 202 on a second side. In embodiments, the first wing 204 and the second wing 206 are coupled to the base 202 via hinges 208, 209. In embodiments, the first wing 204 and/or the second wing 206 contain guards 210a, 210b or other structures that protect and/or isolate the sensors 102. When positioned in a closed configuration, the guards 210a, 210b act as a cage, protecting the sensors 102.

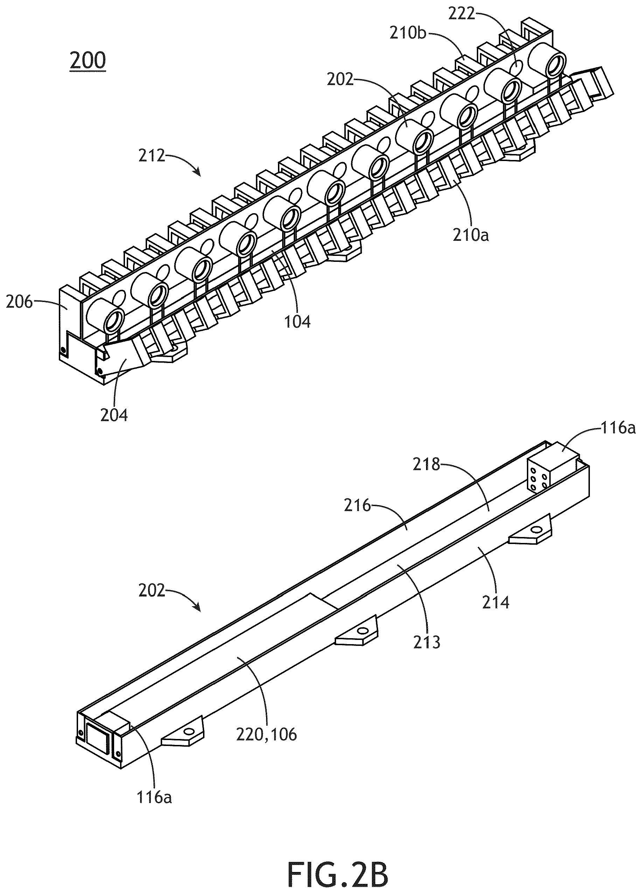

FIG. 2B illustrates a partially exploded view of the sensor assembly 200, in accordance with one or more embodiments of the disclosure. The base 202 is shown isolated from a subassembly 212 that includes the first wing 204 and the second wing 206. The first wing 204 is partially moved or opened to reveal the plurality of sensors 102.

In embodiments, the base 202 includes a base plate 213 and side plates 214, 216 that together form a frame having a cavity 218 that contains or is integrated with one or more components of the sensor assembly 100, such as the subassembly 212. The cavity 218 may be further defined by the first wing 204 and the second wing 206. For example, when the first wing 204 and/or the second wing 206 are moved from a closed position (e.g., as shown in FIG. 2A) to a partially open configuration (e.g., as shown in FIG. 2B), the first wing 204 and the second wing 206 can be seen to form a cavity 218 that contains the plurality of sensors 102. The opening of the first wing 204 in FIG. 2B reveals a terminal block 104 that is communicatively coupled to the plurality of sensors 102. In embodiments, the first wing 204 and second wing 206 are integrated with the respective side plates 214, 216.

In embodiments, the base 202 houses the controller 106. For example, the sensor assembly 200 may include a printed circuit board (PCB 220) or other medium that houses the controller 106. For example, the PCB 220 may be communicatively coupled to the terminal block 104, effectively coupling the plurality of sensors 102 to the controller 106. In embodiments, the controller 106 may include multiple components that are included both within the sensor support 103 and outside the sensor support 103. For example, the PCB 220 may include one or more processors 108 that receive the signals from the terminal block 104, with the controller 106 further including one or more processors 108 outside the sensor support 103 that receive signals from the PCB 220 and further process the signals before sending data to the network.

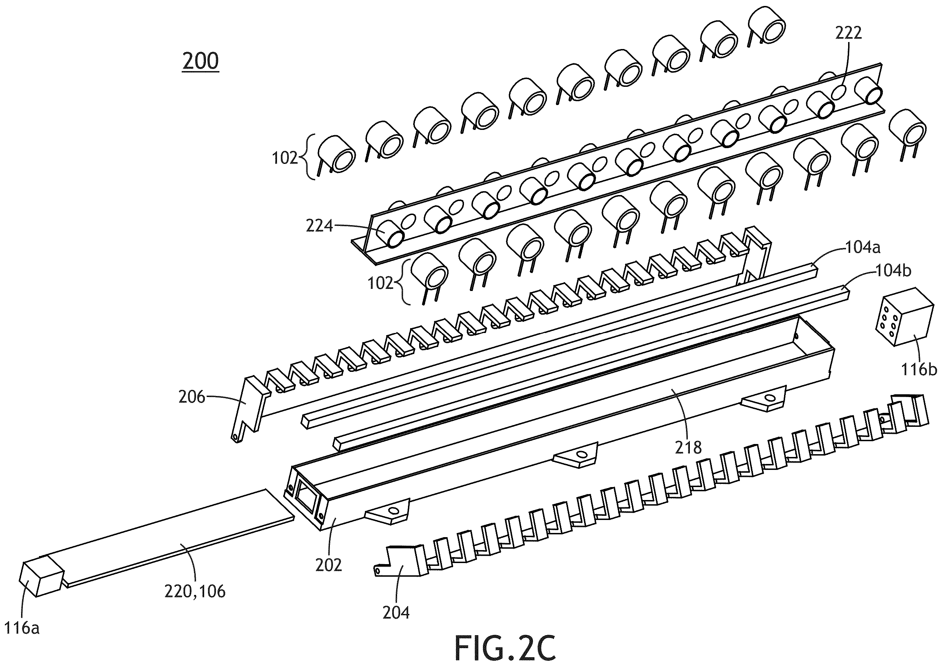

FIG. 2C illustrates an exploded view of the sensor assembly 200, in accordance with one or more embodiments of the disclosure. In embodiments, the sensor assembly includes a support column 222 configured to support the plurality of sensors 102 within the sensor assembly 200. For example, the support column may be disposed within the cavity 218 defined at least partially by the first wing 204 and the second wing 206. The support column 222 may include a plurality of posts 224 that are insertable by the sensors 102. For example, the sensor assembly 200 may be configured to include sensors 102 that include coiled current transformers, having coils that fit around the posts 224.

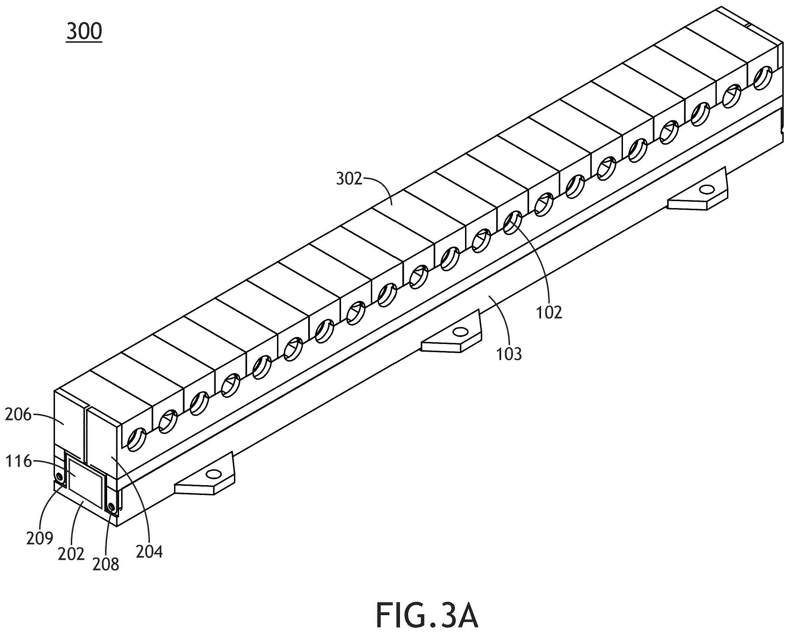

FIG. 3A illustrates a perspective view of a sensor assembly 300, in accordance with one or more embodiments of the disclosure. The sensor assembly 300 may include one or more components of sensor assemblies 100, 200, and vice versa. In embodiments, the sensor assembly 300 includes a plurality of caps 302 that cover the top of the sensor assembly 300 and shield the plurality of sensors 102 from view. The first wing 204 and second wing 206 of the sensor assembly 300 may include a reduced guard 210 or may omit the guard 210. In embodiments, the caps 302 cover, or are integrated into, a split-core current transformer. For example, the caps 302 may be integrated into split-core current transformers (e.g., as a protective cover for the split-core current transformer). For instance, when a faulty split-core current transformer needs to be removed, the cap 302 and/or the split-core transformer may be split, allowing the wires 128, 130 measured encased by the split-core current transformers to be removed. The use of split-core current transformers is particularly advantageous for retrofit applications in which the sensory assembly 300 is installed in a preexisting panel board that lacks current sensing. For example, the split-core lid may be separated so that the branch circuit wiring can be inserted and routed through the core of the split-core transformer, then reinstalled.

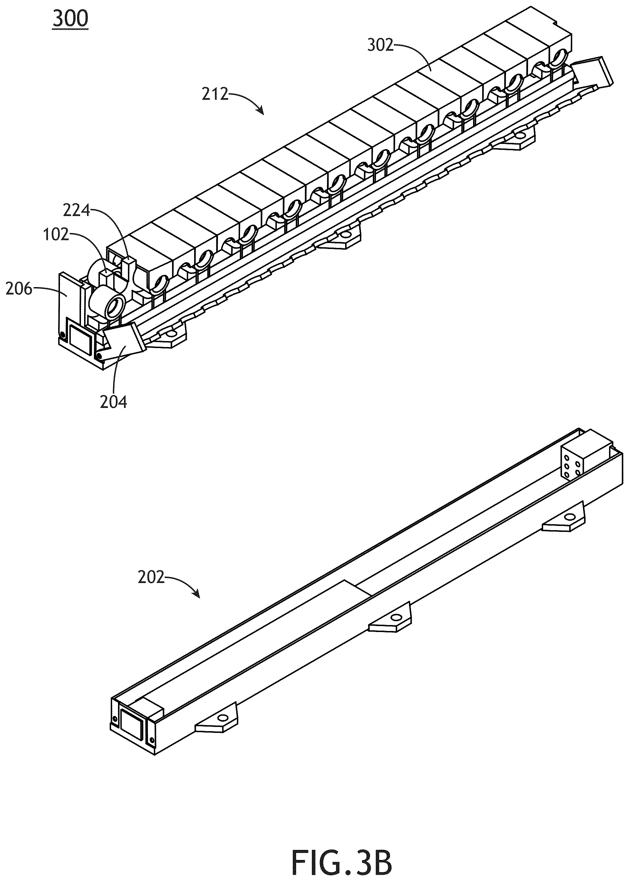

FIG. 3B illustrates a partially exploded view of the sensor assembly 300, in accordance with one or more embodiments of the disclosure. The view includes the base 202 as well as the subassembly 212, with a single cap 302 of the plurality of caps 302 removed. Removal of the cap 302 reveals a sensor 102 of the plurality of the sensors 102 as well as a portion of the support column 222. In embodiments, the cap 302 coupled to the sensor assembly 300 via an interference or friction fit. For example, the cap 302 may be secured to the sensor assembly 300 by fitting at least partially onto the support column 222, the sensor 102, the first wing 204, and/or the second wing 206.

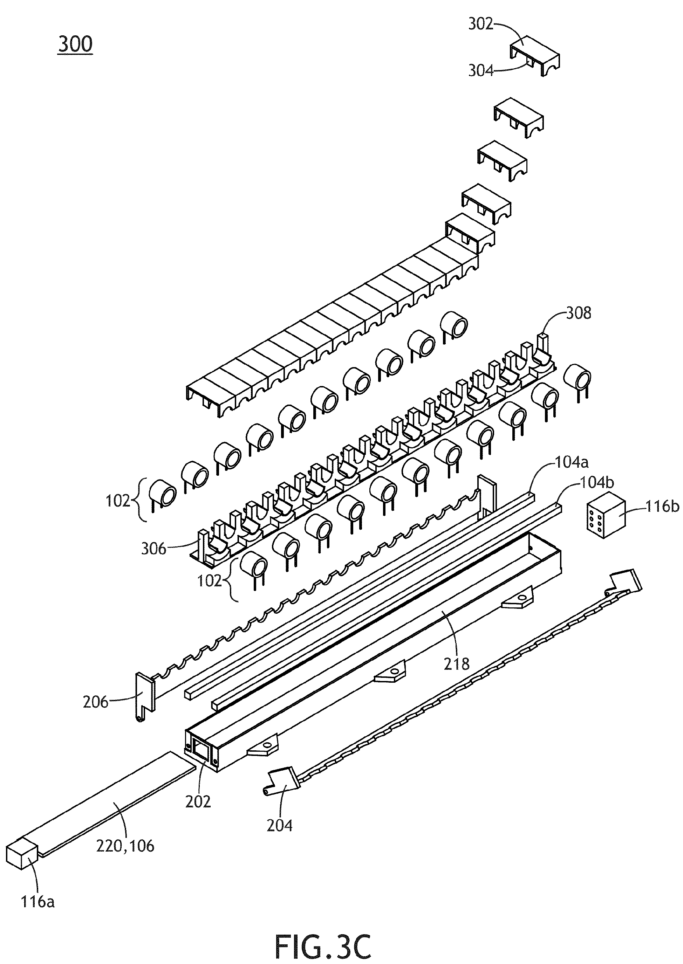

FIG. 3C illustrates an exploded view of the sensor assembly 300, in accordance with one or more embodiments of the disclosure. The plurality of caps 302 are clearly shown, with each cap including one or more protuberances 304 that are involved in providing the interference fit between the cap 302 and the rest of the sensor assembly 300.

In embodiments, the sensor assembly 300 includes a support column 306 that includes a series of brackets 308. For example, one or more sensors 102 of the sensor assembly 300 may fit into the bracket 308, securing the one or more sensors 102.

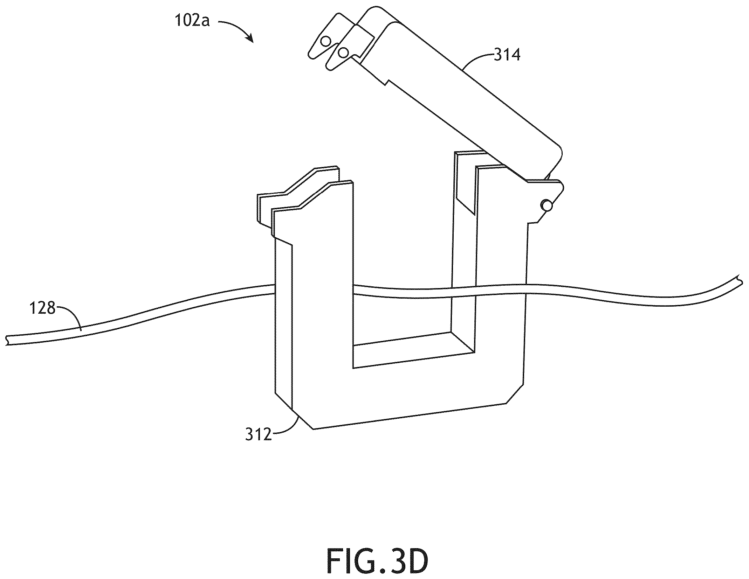

FIG. 3D illustrates a close-up perspective view of a sensor 102a (e.g., a split-core current transformer), in accordance with one or more embodiments of the disclosure. In embodiments, one or more sensors 102a of the plurality of sensors 102 includes a split-core current transformer. For example, any of the sensor assemblies 100, 200, 300 disclosed herein may include one or more split-core current transformers. The split-core current transformer may include a base section 312 and a lid section 314 that can be partially removed from the base section 312, allowing a wire 128 to be removed from the split-core current transformer with 102a without the need to break either the wire or the core of the split-core current transformer. Once replaced, the lid section 314 is closed, reconstituting the core of the split-core current transformer. The base section 312 may be reversibly pluggable into the terminal block 104 as described herein.

It is contemplated herein that the design of the sensor assemblies 100, 200, 300 containing the split-core current transformers, as disclosed herein, may be particularly advantageous for purposes of upgrading electronic componentry in the field. For example, if a current transformer becomes defective, or if a current transformer or other sensor assembly component of improved performance is available, the defective and/or outdated current transformer may be easily swapped out for a new split core current transformer. The use of split-core current transformers is particularly advantageous for retrofit applications in which the sensory assembly 300 is installed in a preexisting panel board that lacks current sensing. For example, the split-core lid may be separated so that the branch circuit wiring can be inserted and routed through the core of the split-core transformer, then reinstalled.

It is further contemplated herein that the sensor assemblies 100, 200, 300 containing the split-core current transformers, as disclosed herein, may be particularly advantageous for purposes of retrofitting older sensor assembly systems. For example, by replacing an older sensor system that does not include split-core current transformers with a sensor assembly 100, 200, 300 containing split-current transformers, the electrical system is then transformed into a field-upgradable and field-repairable system. The use of split-core current transformers is particularly advantageous for retrofit applications in which the sensory assembly 300 is installed in a preexisting panel board that lacks current sensing. For example, the split-core lid may be separated so that the branch circuit wiring can be inserted and routed through the core of the split-core transformer, then reinstalled.

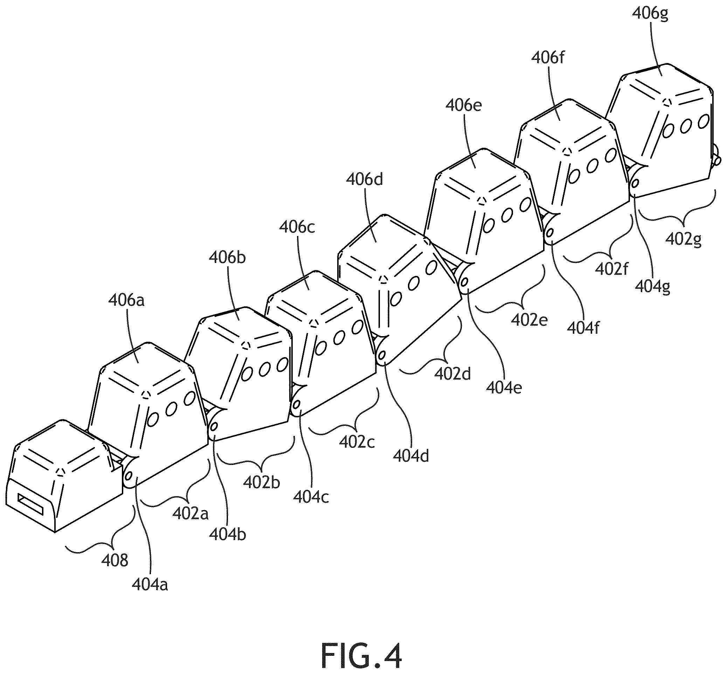

FIG. 4 illustrates a perspective view of a sensor assembly 400, in accordance with one or more embodiments of the disclosure. The sensor assembly 400 may include one or more components of sensor assemblies 100, 200, 300, and vice versa. The sensor assembly 400 illustrates a modular, flexible, and jointed body, which may accommodate different branched circuit wiring topologies.

In embodiments, the sensor assembly 400 is made up of a plurality of sensor segments 402a-g coupled to each other via hinges 404a-g. One or more of the plurality of sensor segments 402a-g may further include a sensor support 406 that includes portions analogous to the base 202, the first wing 204 (or side plate 214) and the second wing 206 (or side plate 216). One or more sensor segments 402a-g of the plurality of segments 402a-g may include, but not be limited to, a sensor 102, a terminal block 104, a controller 106, an auxiliary input 112, a data terminal 114, a daisy chain connector 116, and a display 118 or display port. The sensor assembly 400 may also include one or more terminal segments 408. The one or more terminal segments 408 may function to enable coupling of the sensor assembly 400 to another sensor assembly 100, 200, 300, 400. The sensor segments 402a-g may be both modular and flexible. For example, the sensor assembly 400 may include, and/or be adjusted to have, any number of sensor segments 402 including, but not limited to, three segments, five segments, seven segments, 10 segments, or twenty or more segments. In another example, the sensor segments 404a-gmay be aligned in a non-linear or non-straight arrangement due to the flexible joints that connect the sensor segments 402a-g. For instance, one or more sensor segments 404a-g of the sensor assembly 400 may be configured to align with a curved surface.

In embodiments, the sensor segments 402a-g of the sensor assembly 400 are modular. For example, one or more sensor segments 402 may be added to, or removed from, an existing sensor assembly 400, with each sensor segment 402 capable of monitoring electrical circuits.

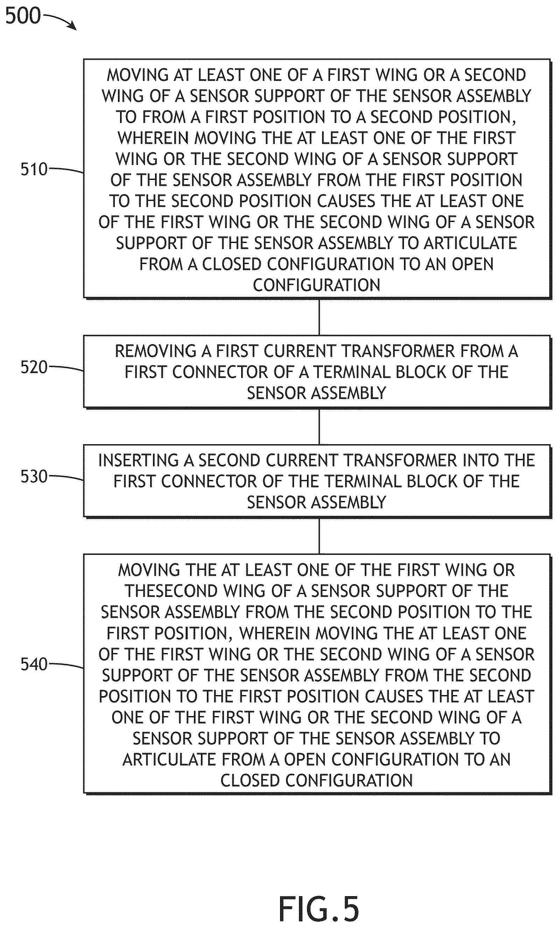

FIG. 5 illustrates a process flow diagram depicting a method 500 for replacing a defective current transformer (e.g., sensor 102) from a sensor assembly, in accordance with one or more embodiments of the disclosure. The method 500 may be utilized by the sensor assembly 100, 200, 300, 400.

In embodiments, the method 500 includes a step 510 of moving at least one of a first wing 204 or a second wing 206 of a sensor support 103 of the sensor assembly 200 to from a first position to a second position, wherein moving (e.g., a movement) the at least one of the first wing or the second wing of the sensor support 103 of the sensor assembly 200 from the first position to the second position causes the at least one of the first wing 204 or the second wing 206 of the sensor support 103 of the sensor assembly 200 to articulate from a closed configuration to an open configuration. For example, in the closed configuration, the sensors 102 are at least partially secured and/or hidden from view so that they are not readily touched or contacted by an operator or other componentry outside of the sensor assembly 100, whereas, in the open configuration, the sensors unhindered by the first wing 204, the second wing, cap 302, and or sensor support 406, allowing an operator to access the sensor 102.

In embodiments, the method 500 includes a step 520 of removing a first current transformer (e.g., a defective sensor 102) from a first block connector of a terminal block 104 of the sensor assembly 100. For example, removing the first current transformer from the first block connector may require pulling on the first current transformer with an operator's fingers or a tool. Because the first current transformer is not soldered into place, the first current transformer can be removed without desoldering. At this time, the conductive wire 128 may be removed from the second current transformer.

In embodiments, the method 500 includes a step 530 of inserting a second current transformer (e.g., a non-defective sensor 102) into the first block connector of the terminal block 104 of the sensor assembly 100. For example, the second current transformer may be pushed into place via an operator's fingers or a tool, with the connection made without soldering. At this time, the conductive wire 128 may be threaded back through the second current transformer.

In embodiments, the method 500 includes a step 540 of moving the at least one of the first wing 204 or the second wing 206 of the sensor support 103 of the sensor assembly 200 from the second position to the first position, wherein moving the at least one of the first wing 204 or the second wing 206 of a sensor support 103 of the sensor assembly 200 from the second position to the first position causes the at least one of the first wing 204 or the second wing 206 of the sensor support of the sensor assembly 200 to articulate from an open configuration to a closed configuration.

The sensor assembly 100 provides a flexible system for monitoring circuits. The first wing 204 and second wing 206 forms a cage structure when closed that allow either bottom-up or top-down attachment to branch circuit wiring. Due to the modularity of the sensor assembly 100, 200, 300, 400, the embedded branch power metering capability provides input power metering without the added cost of additional current transformers. The embedded, non-volatile memory 110 allows for the storage and retrieval of calibration coefficients that are programmed in at manufacturing time. The memory 110 may also instruct the processors 108 to program voltage phase associations with each current transformer. The embedded memory 110 also includes data that may be sufficient to derive related feed input currents so large current transformers, which are costly and can pose electrical hazards with burden removal, are unnecessary. The ability of the sensor assembly to be quickly opened and closed, combined with the non-soldering aspect of the terminal block 104 allows current transformers to be changed in the field, rather than requiring the sensor assembly 100 to be removed from the circuit breaker panel 120 for service.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary. Those skilled in the art will recognize that optical aspects of implementations will typically employ optically oriented hardware, software, and/or firmware.

The one or more processors 108 may include any processor or processing element known in the art. For the purposes of the present disclosure, the term "processor" or "processing element" may be broadly defined to encompass any device having one or more processing or logic elements (e.g., one or more micro-processor devices, one or more application specific integrated circuit (ASIC) devices, one or more field programmable gate arrays (FPGAs), or one or more digital signal processors (DSPs)). In this sense, the one or more processors 108 may include any device configured to execute algorithms and/or instructions (e.g., program instructions stored in memory 110). In one embodiment, the one or more processors 108 may be embodied as any computer system configured to execute a program configured to operate the sensor assembly 100, as described throughout the present disclosure. Moreover, different subsystems of the sensor assembly 100 or circuit breaker panel 120 may include a processor or logic elements suitable for carrying out at least a portion of the steps described in the present disclosure.

The memory 110 can be an example of a tangible, computer-readable storage medium that provides storage functionality to store various data and/or program code associated with operation of the controller 106 and/or other components of the sensor assembly, such as software programs and/or code segments, or other data to instruct the controller 106 and/or other components to perform the functionality described herein. Thus, the memory 110 can store data, such as a program of instructions for operating the sensor assembly 100 or other components. It should be noted that while a single memory 110 is described, a wide variety of types and combinations of memory 110 (e.g., tangible, non-transitory memory) can be employed. The memory 110 can be integral with the controller, can comprise stand-alone memory, or can be a combination of both. Some examples of the memory 110 can include removable and non-removable memory components, such as a programmable logic device, random-access memory (RAM), read-only memory (ROM), flash memory (e.g., a secure digital (SD) memory card, a mini-SD memory card, and/or a micro-SD memory card), solid-state drive (SSD) memory, magnetic memory, optical memory, universal serial bus (USB) memory devices, hard disk memory, external memory, and so forth.

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit sensor support, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.
Further examples are set out in the clauses below:
1. A sensor assembly for wiring in an electrical system, comprising:
   a sensor support comprising:
      a base;
      a first wing coupled to a first side of the base; and
      a second wing coupled to a second side of the base, wherein the base, the first wing, and the second wing form a cavity;
   at least one terminal block disposed within the cavity and communicatively coupled to a controller; and
   a plurality of current transformers, wherein one or more current transformers of the plurality of current transformers are wholly or partially removably couplable to the at least one terminal block when the first wing and the second wing are arranged in an open configuration, wherein the one or more current transformers of the plurality of current transformers are not removable from the at least one terminal block when the first wing and the second wing are arranged in a closed configuration.
2. The sensor assembly of clause 1, wherein at least one current transformer of the plurality of current transformers is a split-core current transformer.
3. The sensor assembly of clause 1 or 2, further comprising a transformer support column disposed within the cavity, the transformer support column comprising a plurality of supports configured to receive a plurality of coils from the plurality of current transformers.
4. The sensor assembly of clause 3, wherein the plurality of supports comprises posts, wherein the posts are insertable by the plurality of coils.
5. The sensor assembly of clause 3, wherein the plurality of supports comprise brackets, wherein the plurality of coils are configured to fit within the brackets.
6. The sensor assembly of any one of clauses 3-5, wherein at least one of the first wing or the second wing is coupled to the base via a hinge, wherein the at least one of the first wing or the second wing is configured to articulate via the hinge between the open configuration and the closed configuration.
7. The sensor assembly of any eon of clauses 3-6, further comprising a plurality of caps, wherein at least one cap of the plurality of caps is configured to couple to a component of the sensor support and cover at least one current transformer of the plurality of current transformers.
8. The sensor assembly of any one of clauses 3-7, wherein the at least one terminal block is comprised of a plurality of removable sensor segments, wherein at least one segment of the plurality of removable sensor segments houses a current transformer of the plurality of current transformers.
9. The sensor assembly of any one of the preceding clauses, further comprising the controller, wherein the controller comprises one or more processors configured to execute program instructions configured to:
   determine a current value from at least one current transformer of the plurality of current transformers; and
   transmit the current value to an output.
10. The sensor assembly of clause 9, further comprising a display configured to receive the output.
11. The sensor assembly of clause 10, wherein the display is integrated into the sensor support.
12. The sensor assembly of any one of the preceding clauses, further comprising a chain connector configured to mechanically couple and electrically couple to another sensor assembly.
13. The sensor assembly of any one of the preceding clauses, further comprising a data terminal configured to transmit data from the sensor assembly to a data collector.
14. A circuit breaker panel comprising:
   a plurality of circuit breakers; and
   a sensor assembly, the sensor assembly comprising:
      a sensor support comprising:
      a base;
      a first wing coupled to a first side of the base; and
      a second wing coupled to a second side of the base, wherein the base, the first wing, and the second wing form a cavity;
      at least one terminal block disposed within the cavity and communicatively coupled to a controller; and
      a plurality of current transformers communicatively coupled to the plurality of circuit breakers, wherein one or more current transformers of the plurality of current transformers are wholly or partially removably couplable to the at least one terminal block when the first wing and the second wing are arranged in an open configuration, wherein the one or more current transformers of the plurality of current transformers are not removable from the at least one terminal block when the first wing and the second wing are arranged in a closed configuration.
15. The circuit breaker panel of clause 14, wherein at least one current transformer of the plurality of current transformers is a split-core current transformer.
16. The circuit breaker panel of clause 14 or 15, wherein the sensor assembly comprises a transformer support column disposed within the cavity, the transformer support column comprising a plurality of supports configured to receive a plurality of coils from the plurality of current transformers.
17. The circuit breaker of clause 16, wherein the plurality of supports comprises posts, wherein the posts are insertable by the plurality of coils.
18. The circuit breaker of clause 16, wherein the plurality of supports comprises brackets, wherein the plurality of coils is configured to fit within the brackets.
19. The circuit breaker of any one of clauses 16-18, wherein at least one of the first wing or the second wing is coupled to the base via a hinge, wherein the at least one of the first wing or the second wing is configured to articulate via the hinge between the open configuration and the closed configuration.
20. A method for replacing a defective current transformer from a sensor assembly, the method comprising:
   moving at least one of a first wing or a second wing of a sensor support of the sensor assembly to from a first position to a second position, wherein moving the at least one of the first wing or the second wing of a sensor support of the sensor assembly from the first position to the second position causes the at least one of the first wing or the second wing of the sensor support of the sensor assembly to articulate from a closed configuration to an open configuration;
   removing a first current transformer from a first block connector of a terminal block of the sensor assembly;
   inserting a second current transformer into the first block connector of the terminal block of the sensor assembly; and
   moving the at least one of the first wing or the second wing of the sensor support of the sensor assembly from the second position to the first position, wherein moving the at least one of the first wing or the second wing of the sensor support of the sensor assembly from the second position to the first position causes the at least one of the first wing or the second wing of the sensor support of the sensor assembly to articulate from the open configuration to the closed configuration.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the true scope of the subject matter described herein.

## Claims

1. A sensor assembly for wiring in an electrical system, comprising:
a sensor support comprising:
a base;
a first wing coupled to a first side of the base; and
a second wing coupled to a second side of the base, wherein the base, the first wing, and the second wing form a cavity;
at least one terminal block disposed within the cavity and communicatively coupled to a controller; and
a plurality of current transformers, wherein one or more current transformers of the plurality of current transformers are wholly or partially removably couplable to the at least one terminal block when the first wing and the second wing are arranged in an open configuration, wherein the one or more current transformers of the plurality of current transformers are not removable from the at least one terminal block when the first wing and the second wing are arranged in a closed configuration.

2. The sensor assembly of claim 1, wherein at least one current transformer of the plurality of current transformers is a split-core current transformer.

3. The sensor assembly of claim 1 or 2, further comprising a transformer support column disposed within the cavity, the transformer support column comprising a plurality of supports configured to receive a plurality of coils from the plurality of current transformers.

4. The sensor assembly of claim 3, wherein the plurality of supports comprises posts, wherein the posts are insertable by the plurality of coils; or optionally
wherein the plurality of supports comprise brackets, wherein the plurality of coils are configured to fit within the brackets; or optionally
wherein at least one of the first wing or the second wing is coupled to the base via a hinge, wherein the at least one of the first wing or the second wing is configured to articulate via the hinge between the open configuration and the closed configuration; or optionally
further comprising a plurality of caps, wherein at least one cap of the plurality of caps is configured to couple to a component of the sensor support and cover at least one current transformer of the plurality of current transformers; or optionally
wherein the at least one terminal block is comprised of a plurality of removable sensor segments, wherein at least one segment of the plurality of removable sensor segments houses a current transformer of the plurality of current transformers.

5. The sensor assembly of any one of the preceding claims, further comprising the controller, wherein the controller comprises one or more processors configured to execute program instructions configured to:
determine a current value from at least one current transformer of the plurality of current transformers; and
transmit the current value to an output.

6. The sensor assembly of claim 5, further comprising a display configured to receive the output; and optionally
wherein the display is integrated into the sensor support.

7. The sensor assembly of any one of the preceding claims, further comprising a chain connector configured to mechanically couple and electrically couple to another sensor assembly.

8. The sensor assembly of any one of the preceding claims, further comprising a data terminal configured to transmit data from the sensor assembly to a data collector.

9. A circuit breaker panel comprising:
a plurality of circuit breakers; and
a sensor assembly, the sensor assembly comprising:
a sensor support comprising:
a base;
a first wing coupled to a first side of the base; and
a second wing coupled to a second side of the base, wherein the base, the first wing, and the second wing form a cavity;
at least one terminal block disposed within the cavity and communicatively coupled to a controller; and
a plurality of current transformers communicatively coupled to the plurality of circuit breakers, wherein one or more current transformers of the plurality of current transformers are wholly or partially removably couplable to the at least one terminal block when the first wing and the second wing are arranged in an open configuration, wherein the one or more current transformers of the plurality of current transformers are not removable from the at least one terminal block when the first wing and the second wing are arranged in a closed configuration.

10. The circuit breaker panel of claim 9, wherein at least one current transformer of the plurality of current transformers is a split-core current transformer.

11. The circuit breaker panel of claim 9 or 10, wherein the sensor assembly comprises a transformer support column disposed within the cavity, the transformer support column comprising a plurality of supports configured to receive a plurality of coils from the plurality of current transformers.

12. The circuit breaker of any one of claims 9-11, wherein the plurality of supports comprises posts, wherein the posts are insertable by the plurality of coils.

13. The circuit breaker of claim 12, wherein the plurality of supports comprises brackets, wherein the plurality of coils is configured to fit within the brackets.

14. The circuit breaker of any one of claims 9-13, wherein at least one of the first wing or the second wing is coupled to the base via a hinge, wherein the at least one of the first wing or the second wing is configured to articulate via the hinge between the open configuration and the closed configuration.

15. A method for replacing a defective current transformer from a sensor assembly, the method comprising:
moving at least one of a first wing or a second wing of a sensor support of the sensor assembly to from a first position to a second position, wherein moving the at least one of the first wing or the second wing of a sensor support of the sensor assembly from the first position to the second position causes the at least one of the first wing or the second wing of the sensor support of the sensor assembly to articulate from a closed configuration to an open configuration;
removing a first current transformer from a first block connector of a terminal block of the sensor assembly;
inserting a second current transformer into the first block connector of the terminal block of the sensor assembly; and
moving the at least one of the first wing or the second wing of the sensor support of the sensor assembly from the second position to the first position, wherein moving the at least one of the first wing or the second wing of the sensor support of the sensor assembly from the second position to the first position causes the at least one of the first wing or the second wing of the sensor support of the sensor assembly to articulate from the open configuration to the closed configuration.
